(19) Europäisches Patentamt
European Patent Office
Office européen des brevets

(11) EP 0 743 559 B1

(12) **EUROPEAN PATENT SPECIFICATION**

(45) Date of publication and mention of the grant of the patent:
**13.03.2002 Bulletin 2002/11**

(51) Int Cl.[7]: **G03F 7/023**, G03F 7/022

(21) Application number: **96106268.4**

(22) Date of filing: **22.04.1996**

(54) **Controlled-acidity photosensitive compositions for offset printing**

Fotoempfindliche Zusammensetzungen mit gesteuertem Säuregrad für Offsetdruck

Compositions photosensibles à indice d'acide contrôlé pour l'impression offset

(84) Designated Contracting States:
**AT BE CH DE DK ES FI FR GB GR IE IT LI LU MC NL PT SE**

(30) Priority: **19.05.1995 IT MI951019**

(43) Date of publication of application:
**20.11.1996 Bulletin 1996/47**

(73) Proprietor: **PLURIMETAL S.R.L.**
**37050 Vallese di Oppeano (Verona) (IT)**

(72) Inventor: **Rinaldi, Rinaldo**
**37050 Vallese di Oppeano (VR) (IT)**

(74) Representative: **Bianchetti, Giuseppe, Prof.**
**Bianchetti Bracco Minoja S.r.l.**
**Via Rossini, 8**
**20122 Milano (IT)**

(56) References cited:
**EP-A- 0 054 258**
**EP-A- 0 660 186**
**DE-A- 3 839 714**
**DE-A- 3 839 906**
**GB-A- 2 075 700**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

The present invention relates to photosensitive compositions for offset printing, in particular for offset plates.

Background of the invention

Photosensitive mixtures used in the manufacture of offset printing plates have been known already for many years, during which time continuous efforts on the part of researchers have resulted in an improvement in the functional characteristics thereof, with both the introduction of new chemical compounds and modification of the physical structure of the sensitized plate system.

The sensitive layer of a positive lithographic plate usually contains a derivative of the 0-quinone diazide as the photosensitive compound, and an alkali-soluble resin, the function of which is to improve the applicational characteristics of the plates.

The term "applicational characteristics" is understood here as referring to those aspects which are important for the users of plates during the normal printing process. In fact, over the years, all research efforts have been directed towards obtaining an improved operational performance, such as:

- an increase in the sensitivity of the photosensitive layer;
- improved developability in increasingly diluted aqueous media;
- better reproduction of positive and negative originals;
- increase in the resistance to print runs and chemical products used in machines;
- stability, over time, of the sensitive layer;
- ease of production and overall reduction in costs.

All of the parameters described, together with other associated parameters, depend to a significant extent on the chemical composition of the sensitive layer.

A particular problem concerns the degree of adhesion of the photosensitive mixtures to substrates such as aluminium.

The derivatives of the sulfoquinone acid diazides, in particular 1,2-naphthoquinone-4-sulfonic acid diazide and 1,2-naphthoquinone-5-sulfonic acid diazide, are mainly used as the photosensitive material; these are used preferably as "diazo resins", i.e. products obtained from the reaction of partial or total esterification of the sulfonyl group with the hydroxyl groups of polymer compounds of variable molecular weight containing -OH groups in their structure or with polyhydroxylated molecules of low molecular weight.

Examples of polymer compounds are phenolic resins, obtained by means of the known condensation phenol formaldehyde, including preferably the novolak resins obtained from esterification of cresol formaldehyde in which the cresol may be present in the various ortho, meta and para isomers in varying ratios with one another.

The reaction of novolak resin with 1,2 naphthoquinone sulfonyl diazide derivative results in a series of products called "diazo resins" which, depending on the starting products and the evolution of the esterification reaction, may have applicational characteristics which are different both from the point of view of the sensitivity to UV light and as regards the developability, the mechanical strength of the layer and the chemical resistance to the chemical products present during the printing processes.

GB-A-2075700 discloses a light-sensitive composition comprising a mixture of a diazo resins and an alkali-soluble resin with a molecular weight that is low enough to give the compatibility necessary for stability of the mixture, but high enough for the resin to have a useful reinforcing effect. Examples of such an alkali-soluble resin are vinyl chloride/vinyl acetate co-polymer, polyvinyl acetate polyvinyl acetal or epoxy resin derived from epichloridrin and bisphenol A.

EP 0660186, which is considered as prior art according to Article 54(3) EPC, discloses a photosensitive composition comprising a diazo resin, an alkali-soluble resin, which is a polycondensation product of a phenolic compound, formaldehyde and a carbonyl compound of formula $R_6R_7C{=}O$, wherein each of $R_6$ and $R_7$, which are independent of each other, is a hydrogen atom, a $C_1$-$C_4$ lower alkyl group, an aryl group or an aralkyl group, provided that $R_6$ and $R_7$ are not simultaneously hydrogen atoms.

It has been seen that the degree of acidity of the photosensitive compositions influences the adhesion thereof to the plate substrate after the normal drying process, or evaporation of the solvent, so as to obtain a solid film. In particular, this occurs in the case of aluminium substrates which have been roughened beforehand and then anodized. The adhesion decreases with an increase in the acidity.

Moreover, it has been seen that the sensitivity to UV light of the plates produced is directly proportional to the degree of acidity.

Description of the invention

It has now been found that photosensitive compositions for offset printing with a controlled degree of acidity possess an optimum balance in terms of adhesion to the substrate and sensitivity to UV light.

Therefore, the present invention relates to photosensitive compositions with a controlled degree of acidity, to their use for the manufacture of offset printing plates and to said plates provided with the sensitive layer comprising said compositions.

Detailed description of the invention

According to a first embodiment of the present invention, the photosensitive compositions contain from 20 to 90% of a diazo resin with an esterification index of between 20 and 40%, preferably between about 20 and 30%, and a nitrogen content of between 2 and 3%, preferably between 2.3 and 2.7%, from 0 to 60% of an alkali-soluble novolak resin, as well as any other conventional components. Said compositions are characterized in that they have an acidity value, expressed as Electromotive Force (EMF) and measured using a specific electrode for non-aqueous solvents, of between 100 and 400 millivolts, preferably between 150 and 300 millivolts.The amounts in percent are expressed by weight of total solids.

A diazc resin is commonly understood as being the reaction product of a derivative of the sulfoquinone acid diazide with a polymer compound of variable molecular weight containing OH groups; a diazo ester is commonly understood as being the reaction product of a derivative of the sulfoquinone acid diazide with polyhydroxylated molecules of low molecular weight.

According to a preferred embodiment of the invention, the diazo resin consists of the reaction product of a 1,2-naphthoquinone sulfonic acid diazide, preferably in the form of chloride, with a phenolic resin.

According to a more greatly preferred embodiment, the sulfonic acid is selected from the group consisting of 1,2-naphthoquinone-4-sulfonic acid diazide and 1,2-naphthoquinone-5-sulfonic acid diazide.

According to an ever more greatly preferred embodiment, said resin is a cresol-formaldehyde resin, in particular a resin with a molecular weight of between 600 and 900, preferably between 700 and 800, as described by Megson and Hollingdale, J. Appl. Chem. 5, 616.

The characteristic features of this product are a notable sensitivity to UV radiation, of between 350 to 370 nm, good solubility in ordinary solvents, stability over time and ease of production.

In a second embodiment thereof, the photosensitive compositions of the present invention contain a UV-absorbing compound in order to increase the radiation sensitivity. These compounds are known in the art as diazo esters.

According to a preferred embodiment, derivatives of benzophenone, containing hydroxyl groups, such as for example those which are mono-, di-, tri- and tetra-substituted in the various positions, are used as the UV absorbers.

Examples of these are illustrated in numerous patents, for example EP 0 362 778, US 4 409 314, DE 2 742 631, DE 3 711 263, EP 0 088 346, EP 0 056 092, EP 0 055 814 and others. Most of these patents describe various derivatives obtained from benzophenone, generally di- and tri-hydroxy derivatives, also esterified with various molecules including in particular sulfonated derivatives of o-quinone-diazides.

In a more greatly preferred embodiment, said UV absorber is an ester or a mixture of esters of the formula 1

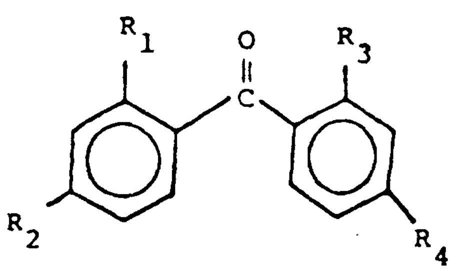

(1)

where $R_1$, $R_2$, $R_3$ and $R_4$, identical to or different from one another, are hydroxyl or a radical of the formula 2 or 2'

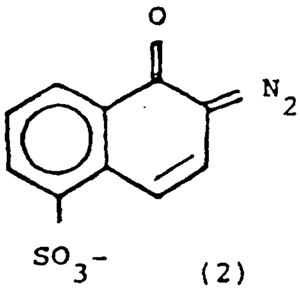

(2)

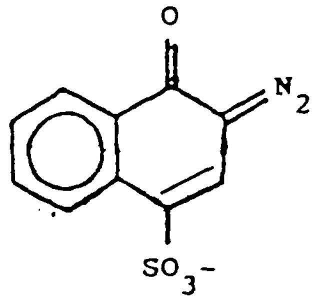

(2')

with the proviso that at least one of $R_1$ to $R_4$ is a radical of the formula 2 or 2'. Said compounds are described for example in DE 2 545 697 and US 5 358 823 and demonstrate a high degree of absorption of between 350 and 400 nm.

In a more greatly preferred embodiment, said UV absorbers consist of a mixture of compounds of the formula 1 and consisting of:

| | |
|---|---|
| tetraester | 80 - 100% |
| triester | 0 - 20% |
| diester | 0 - 5% |
| monoester | 0 - 5% |

Even more preferably, the mixture consists of at least 85% of tetraester, no more than 10% of triester and no more than 5% of the sum of mono- and diester.

This mixture of esters of the formula 1 are comprised within the scope of the invention.

According to the present invention, control of the degree of acidity is obtained by suitably dosing the diazo resin, the diazo ester and the other components or by choosing the esterification index and/or the nitrogen content within the aforementioned range.

The acidity is determined using conventional techniques known to the person skilled in the art, for example using a specific electrode for non-aqueous media (for example as supplied by INGOLD), connected to a normal pH/mV meter.

The system is calibrated with two reference solutions in order to establish a calibration curve of the electrode. The values which are obtained from this system, as already mentioned, cannot be assimilated with the concept of pH, but in any case provide an indication and can be reproduced for the mixtures under examination.

The acidity value read for the solvent mixture can be expressed via the EMF of the cell thus formed

$$(Pt)H_2(1\ atm) \mid solvent\ solution \mid\mid KCl\ (sat),\ Hg_2Cl_2(aq.) \mid H_g$$

Indicating the EMF values of the half-cells by E1 and E2 and assuming the residual diffusion potential to be negligible, the relative acidities of the two solutions are provided by the equation

$$-\log(a_{H+})_1 = -\log(a_{H+})_2 + (E1-E2)/(2,303RT/F).$$

On the basis of this equation it is possible to determine, for each solvent, an acidity standard and hence establish the acidity of unknown solutions on a conventional scale, in a similar manner to that performed for the pH scale in an aqueous medium. Since the diffusion potentials at the interface between various solvents are often extremely variable, it is preferred to indicate the results of the potentiometric measurements of the degree of acidity in non-aqueous media, by directly indicating the EMF of a cell of the type

$$glass\ electrode \mid solvent\ solution \mid\mid standard\ electrode\ H_2$$

a result which is therefore expressed in terms of acidity potential rather than in terms of apparent pH.

Control of the acidity is also regulated by the content of the compound (1) which, at the same time, also influences the sensitivity to UV radiation. In fact, the esterification reaction results in an isomer mixture, the composition

of which determines the chemical and physical characteristics of the preparation.

In particular, the characteristic of an increase in the sensitivity of the system, or the improvement in the efficiency of absorption of UV frequencies, is linked to the basicity of this preparation, which is increased by the greater availability of electronic doublets present both on the nitrogen atoms of the esterified quinone diazide groups and on the oxygen atoms of the carbonyl group. See, for example, "Photopolymerization of surface coatings" by C.G. Roffey, which describes the function of benzophenone derivatives as being that of a base which is able to accept the protons derived from photolysis of the quinone diazide groups. An increase in the basicity of the derivative in question is therefore obtained by having a greater number of nitrogen atoms available in the molecule, which means obtaining in the isomer mixture the maximum quantity of tetra-substituted derivative to the detriment of the tri-, di- and mono-substituted derivative.

It has been found that the maximum efficiency in absorption of UV radiation is obtained with the mixtures of esters described above. This mixture represents a further subject of the invention, as does also its use for the manufacture of photosensitive compositions for offset printing.

The composition of the photosensitive mixture will therefore be determined by the need to obtain an acid characteristic which is predominant, but suitable for the needs already mentioned; in the examples given, the procedure for controlling the acidity and the formulations relating to some photosensitive mixtures according to the present application are indicated.

The compositions will contain other components, which are usual in the known art, such as dyes, which are generally basic, derivatives of triphenylmethane, and additives such as levelling agents, surfactants, anti-oxidising agents, etc.

In particular, attention is given to the presence of substances able to release acids by means of irradiation, the presence of which plays a decisive role in increasing the contrast of the image following exposure; the preferred compounds are derivatives of triazines, including, preferably, that described in Italian Patent No. 1,245,370, with the formula

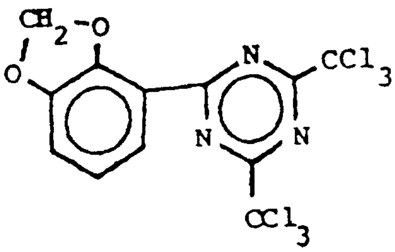

(3)

These components are present in the mixture in a percentage of between 0.1 and 5, preferably between 1 and 2. They perform a particular function consisting in increasing the acidity of the medium during irradiation with formation of Lewis acids.

According to a third embodiment, the compositions of the present invention may contain a suitable quantity of an acid having a pKa of between 3 and 9 depending on the acidity corrector during the interval which represents a critical feature of the invention.

The following examples further illustrate the invention.

## EXAMPLE 1

1) Esterification product of a 2,1-naphthoquinone-5-sulfonyl chloride diazide with a cresol formaldehyde resin, according to the present invention 60%
2) Novolak resin (Bakelite 6564) 30%
3) Esterification product of 2,2',4,4'-tetrahydroxy benzophenone with a 2,1-naphthoquinone-5-sulfonyl chloride diazide 7%
4) Triazine derivative 1.5%
5) Crystal violet dye 1.5%

The components are dissolved in dimethylketone in order to obtain a solid concentration of about 15-20%

suitable for the chosen application system.

The acidity of the mixture is controlled by means of a specific electrode for non-aqueous media (INGOLD), connected to a normal pH/mV meter.

The EMF of the solution obtained according to the formulation described above, at 20°C, is as follows:

EMF = 250 millivolts

Using this solution, a pre-sensitized plate was then prepared, coating it with a grained and anodized aluminium substrate, on which the following tests were performed:

| | |
|---|---|
| Sensitivity (UGRA test) | steps 1 to 4 eliminated |
| Adhesion (Tape test) | 5 minutes in 50% IPA* |

*50% IPA is a 50% solution of Isopropyl Alcohol in water. The test is carried out at 24°C.

The other applicational characteristics also proved to be satisfactory.

**EXAMPLE 2**

As in Example 1, a mixture was prepared in which the component 1) was substituted by

1) Esterification product of 2,1-naphthoquinone-5-sulfonyl chloride diazide with a cresol formaldehyde resin, having a degree of esterification of between 50 and 60% and a nitrogen content of 3.4%.

The EMF measured gave the value:

EMF = 35 mV at 20°C

A plate was then prepared in the same manner as above and subjected to the following sensitivity and adhesion tests:

| | |
|---|---|
| Sensitivity (UGRA test) | steps 1 and 2 eliminated |
| Adhesion (Tape test) | 6 minutes in 50% IPA* |

From this example it can be deduced that an increase in the basicity of the system produced a reduced sensitivity for the same adhesion of the photosensitive layer.

**EXAMPLE 3**

As in Example 1, a mixture was prepared and 2% of parahydroxybenzoic acid (pKa = 4.48) was added; the acidity was measured as being:

EMF = 380 mV at 20°C

After preparing a plate using the normal procedure, the following results were obtained:

| | |
|---|---|
| Sensitivity (UGRA test) | steps 1 to 6 eliminated |
| Adhesion (Tape test) | 2 minutes in 50% IPA* |

In this case also the increase in the acidity improved the sensitivity of the system, while resulting in reduced adhesion thereof to the substrate.

**EXAMPLE 4**

As in Example 1, a mixture was prepared and 2% of trimethylamine (pKb = 9.81) was added to the composition thereof; measurement of the EMF gave the following value:

$$EMF = 80\ mV\ at\ 20°C$$

After preparing a pre-sensitized plate, the following tests were carried out:

| | |
|---|---|
| Sensitivity (UGRA test) | steps 1 to 3 eliminated |
| Adhesion (Tape test) | 5 minutes in 50% IPA* |

In this example, the increase in the basicity of the system obtained with introduction of a proton acceptor increased the adhesion of the sensitive layer, but caused a decrease in the speed of photolysis.

**EXAMPLE 5**

A mixture with the following composition was prepared:

1) Esterification product of a 2,1-naphthoquinone-4-sulfonyl chloride diazide with a cresol formaldehyde resin, according to the present invention 60%
2) Novolak resin (Bakelite 6564) 30%
3) Esterification product of a 2,2',4,4'-tetrahydroxy benzophenone and a 2,1-naphthoquinone-4-sulfonyl chloride diazide 7%
4) Triazine derivative 1.5%
5) Crystal violet dye 1.5%

The mixture was dissolved in acetone in order to obtain a solid concentration of between 15 to 20% by weight suitable for the application system.
The EMF measured for this mixture was as follows:

$$EMF = 260\ mV\ at\ 20°C$$

Plates were then prepared using the usual method, with a grained and anodized aluminium substrate. The results are as follows:

| | |
|---|---|
| Sensitivity (UGRA test) | steps 1 to 4 eliminated |
| Adhesion (Tape test) | 5 minutes in 50% IPA* |

and are entirely identical to those obtained in Example 1. This composition demonstrates a good equivalence between the products obtained from esterification using both 2,1-naphthoquinone-5-sulfonyl chloride and -4-sulfonyl chloride diazide as the starting product.
The results of the acidity measurements are in fact similar to one another, as are also the applicational characteristics. An important difference can be noted only when the plates thus obtained, which are considered to be positive, are subjected to the reversal process in order to transform them into negatives, as described in the patents GB 2 082 339, EPA 0 361 907, EPA 0 550 893 A1, Italian Patent 1 169 682 and others. In this procedure the mixture described in Example 1 does not provide satisfactory results, while the mixture described in this example provides optimum applicational characteristics. The reason for this behaviour, however, is not linked to the different acidity of the mixtures but to the different behavioural response to the temperature of the 4 and 5 derivatives of the naphthoquinone diazide.
The confirmation that the increase in acidity of the system has a favourable effect on the photolysis of the quinone diazides, also in the presence of derivatives of the benzophenone, is confirmed by the UV spectra of the 2,2', 4'4'-tetrahydroxy-benzophenone derivative in solutions with different acidity. A sample acidified with 2% of para-hydroxybenzoic acid resulted in a more marked UV absorption, an indication of the smaller amount of energy required for the transitions $\pi \Rightarrow \pi^*$.

## Claims

**Claims for the following Contracting States : AT, BE, CH, LI, DK, ES, FI, FR, GR, IE, IT, LU, MC, NL, PT, SE**

1. Photosensitive compositions comprising from 20 to 90% by weight of total solids of a diazo resin with an esterification index of between 20 and 40% and a nitrogen content of between 2 and 3%, from 0 to 60% by weight of total solids of an alkali-soluble novolak resin, as well as any other conventional components, **characterized in that** said compositions have an acidity value, expressed as Electromotive Force and measured in dimethylketone using a specific electrode for non-aqueous solvents, of between 100 and 400 millivolts.

2. Compositions according to claim 1, **characterized in that** said acidity value is between 150 and 300 millivolts.

3. Compositions according to claim 1 or 2, wherein said diazo resin consists of the reaction product of a 1,2-naphthoquinone sulfonic acid diazide with a phenolic resin.

4. Compositions according to claim 3, wherein said 1,2-naphthoquinone sulfonic acid diazide is selected from the group consisting of 1,2-naphthoquinone-4-sulfonic acid diazide and 1,2-naphthoquinone-5-sulfonic acid diazide.

5. Compositions according to claim 3 or 4, wherein said phenolic resin is a cresol formaldehyde resin.

6. Compositions according to claim 5, wherein said cresol formaldehyde resin has molecular weight of between 600 and 900.

7. Compositions according to any one of the preceding claims, further containing at least one UV absorbing compound.

8. Compositions according to claim 7, wherein said UV absorber is a compound or a mixture of compounds of formula 1

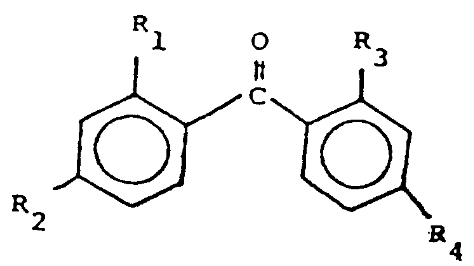

(1)

where $R_1$, $R_2$, $R_3$ and $R_4$, identical to or different from one another, are hydroxyl or a radical of formula 2 or 2'

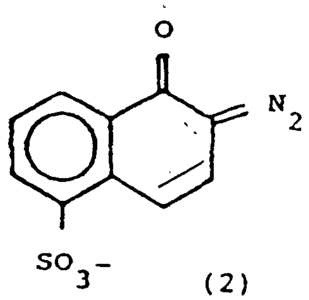

(2)

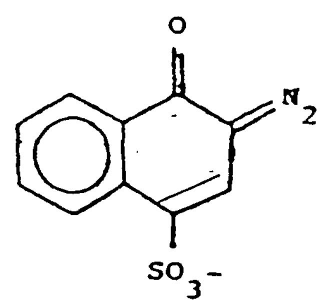

(2')

with the proviso that at least one of $R_1$ to $R_4$ is a radical of formula 2 or 2'.

9. Compositions according to claim 8, wherein said mixture of compounds of formula 1 consists of:

| | |
|---|---|
| tetraester | 80 - 100% by weight of total solids |
| triester | 0 - 20% by weight of total solids |
| diester | 0 - 5% by weight of total solids |
| monoester | 0 - 5% by weight of total solids |

**10.** Compositions according to claim 9, wherein said mixture consists of: at least 85% by weight of total solids of tetraester, no more than 10% of triester, and no more than 5% of the sum of mono- and diester.

**11.** Compositions according to any one of claims 1 to 10, containing from 0.1 to 5% by weight of total solids of compound 3:

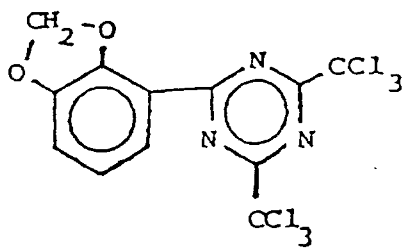

(3)

**12.** Compositions according to any one of the preceding claims, containing a suitable amount of an acid having a pKa value of between 3 and 9.

**13.** Use of the compositions according to claims 1 to 12 for the manufacture of offset printing plates.

**14.** Offset printing plates **characterized in that** the sensitive layer comprises a mixture according to claims 1 to 12.

**15.** Plates according to claim 14, wherein the substrate is grained and anodized aluminium.

**16.** Mixture of compounds of formula 1:

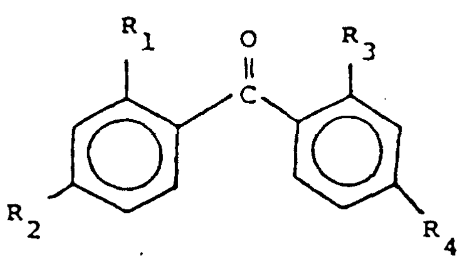

(1)

where $R_1$, $R_2$, $R_3$ and $R_4$, identical to or different from one another, are hydroxyl or a radical of formula 2 or 2'

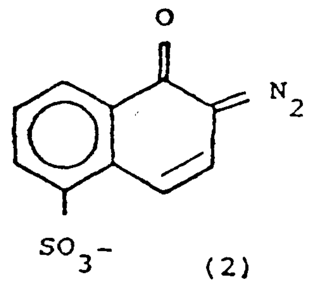

(2)

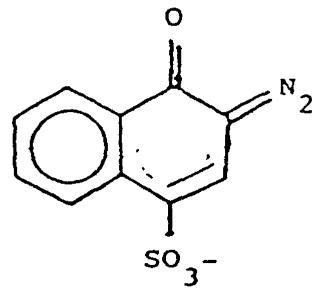

(2')

said mixture consisting of:

- 80-100% of a compound of formula 1, where $R_1$, $R_2$, $R_3$ and $R_4$ are a radical of formula 2 or 2';
- 0-20% of a compound of formula 1, wherein one of $R_1$, $R_2$, $R_3$ and $R_4$ is hydroxyl;
- 0-5% of a compound of formula 1, wherein two of $R_1$, $R_2$, $R_3$ and $R_4$ are hydroxyl;
- 0-5% of a compound of formula 1, wherein three of $R_1$, $R_2$, $R_3$ and $R_4$ are hydroxyl.

**17.** Mixture according to claim 16, consisting of at least 85% of a compound of formula 1, wherein $R_1$, $R_2$, $R_3$ and $R_4$ are an ester radical of formula 2 or 2'; no more than 10% of a compound of formula 1, wherein one of $R_1$, $R_2$, $R_3$ and $R_4$ is hydroxyl and no more than 5% of the sum of compounds of formula 1, where two or three of $R_1$, $R_2$, $R_3$ and $R_4$ are hydroxyl.

**18.** Use of the mixture according to claim 16 or 17 for the manufacture of a photosensitive mixture for offset printing plates.

**Claims for the following Contracting States : GB, DE**

**1.** Photosensitive compositions comprising from 20 to 90% by weight of total solids of a diazo resin with an esterification index of between 20 and 40% and a nitrogen content of between 2 and 3%, from 0 to 60% by weight of total solids of an alkali-soluble novolak resin, as well as any other conventional components, said compositions having an acidity value, expressed as Electromotive Force and measured in dimethylketone using a specific electrode for non-aqueous solvents, of between 100 and 400 millivolts and said compositions comprising a UV absorber which is a mixture of at least 85% by weight of total mixture solids of tetraester, no more than 10% by weight of total mixture solids of triester and no more than 5% by weight of total mixture solids of the sum of mono- and diester of 2,2',4,4-tetrahydroxybenzophenone with 1,2-naphtoquinone diazide-4- or -5-sulfonic acids.

**2.** Compositions according to claim 1, **characterized in that** said acidity value is between 150 and 300 millivolts.

**3.** Compositions according to claim 1 or 2, wherein said diazo resin consists of the reaction product of a 1,2-naphthoquinone sulfonic acid diazide with a phenolic resin.

**4.** Compositions according to claim 3, wherein said 1,2-naphthoquinone sulfonic acid diazide is selected from the group consisting of 1,2-naphthoquinone-4-sulfonic acid diazide and 1,2-naphthoquinone-5-sulfonic acid diazide.

**5.** Compositions according to claim 3 or 4, wherein said phenolic resin is a cresol formaldehyde resin.

**6.** Compositions according to claim 5, wherein said cresol formaldehyde resin has molecular weight of between 600 and 900.

**7.** Compositions according to any one of claims 1 to 6, containing from 0.1 to 5% by weight of total solids of compound 3:

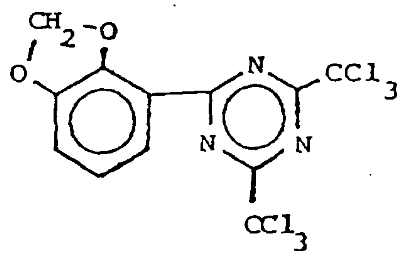

(3)

8. Compositions according to any one of the preceding claims, containing a suitable amount of an acid having a pKa value of between 3 and 9.

9. Use of the compositions according to claims 1 to 8 for the manufacture of offset printing plates.

10. Offset printing plates **characterized in that** the sensitive layer comprises a mixture according to claims 1 to 8.

11. Plates according to claim 10, wherein the substrate is grained and anodized aluminium.

12. Mixture of compounds of formula 1:

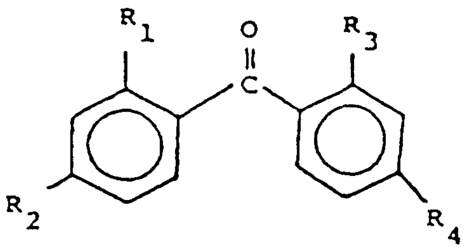

(1)

where $R_1$, $R_2$, $R_3$ and $R_4$, identical to or different from one another, are hydroxyl or a radical of formula 2 or 2'

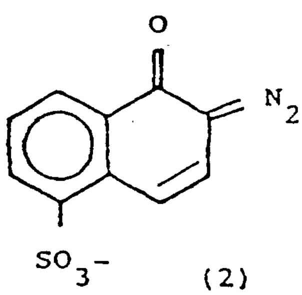

(2)

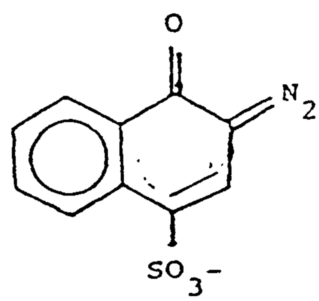

(2')

said mixture consisting of:

- 80-100% of a compound of formula 1, where $R_1$, $R_2$, $R_3$ and $R_4$ are a radical of formula 2 or 2';
- 0-20% of a compound of formula 1, wherein one of $R_1$, $R_2$, $R_3$ and $R_4$ is hydroxyl;
- 0-5% of a compound of formula 1, wherein two of $R_1$, $R_2$, $R_3$ and $R_4$ are hydroxyl;
- 0-5% of a compound of formula 1, wherein three of $R_1$, $R_2$, $R_3$ and $R_4$ are hydroxyl.

13. Mixture according to claim 12, consisting of at least 85% of a compound of formula 1, wherein $R_1$, $R_2$, $R_3$ and $R_4$ are an ester radical of formula 2 or 2'; no more than 10% of a compound of formula 1, wherein one of $R_1$, $R_2$, $R_3$ and $R_4$ is hydroxyl and no more than 5% of the sum of compounds of formula 1, where two or three of $R_1$, $R_2$, $R_3$

and $R_4$ are hydroxyl.

**14.** Use of the mixture according to claim 12 or 13 for the manufacture of a photosensitive mixture for offset printing plates.

**Patentansprüche**

**Patentansprüche für folgende Vertragsstaaten : AT, BE, CH, LI, DK, ES, FI, FR, GR, IE, IT, LU, MC, NL, PT, SE**

**1.** Lichtempfindliche Zusammensetzungen, die einen Gesamtanteil von 20 bis 90 Gewichtsprozent an Feststoffen eines Diazoharzes mit einem Veresterungsindex im Bereich von 20 und 40% und einem Stickstoffgehalt zwischen 2 und 3%, einen Anteil von 0 bis 60 Gewichtsprozent an Feststoffen eines alkalilöslichen Novolak-Harzes sowie weitere herkömmliche Komponenten umfassen, **dadurch gekennzeichnet, dass** diese Zusammensetzungen einen als elektromotorische Kraft ausgedrückten Säurewert im Bereich von 100 und 400 mV haben, der in Dimethylketon mit einer speziellen Elektrode für wasserfreie Lösungsmittel gemessen wird.

**2.** Zusammensetzungen nach Anspruch 1, **dadurch gekennzeichnet, dass** der Säurewert zwischen 150 und 300 Millivolt liegt.

**3.** Zusammensetzungen nach Anspruch 1 oder 2, **dadurch gekennzeichnet, dass** das Diazoharz aus dem Reaktionsprodukt von 1,2-Naphthochinon-Sulfonsäurediazid mit einem Phenolharz besteht.

**4.** Zusammensetzungen nach Anspruch 3, **dadurch gekennzeichnet, dass** das 1,2-Naphthochinon-Sulfonsäurediazid aus der aus 1,2-Naphthochinon-4-Sulfonsäurediazid und 1,2-Naphthochinon-5-Sulfonsäurediazid bestehenden Gruppe ausgewählt wird.

**5.** Zusammensetzungen nach Anspruch 3 oder 4, **dadurch gekennzeichnet, dass** das Phenolharz ein Kresol-Formaldehydharz ist.

**6.** Zusammensetzungen nach Anspruch 5, **dadurch gekennzeichnet, dass** das Kresol-Formaldehydharz ein Molekulargewicht zwischen 600 und 900 hat.

**7.** Zusammensetzungen nach einem der vorstehenden Ansprüche, die weiterhin eine Verbindung enthalten, die UV-Strahlung absorbiert.

**8.** Zusammensetzungen nach Anspruch 7, **dadurch gekennzeichnet, dass** das UV-Absorbens eine Verbindung oder ein Verbindungsgemisch der Formel 1 ist,

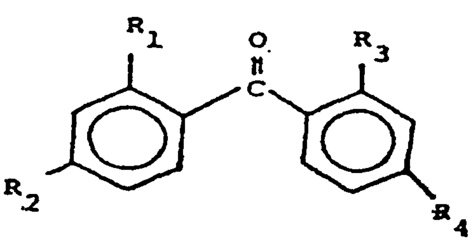

(1)

wobei R1, R2, R3 und R4 gleich oder verschieden voneinander sind und einen Hydroxylrest oder ein Radikal der Formel 2 oder 2' darstellen

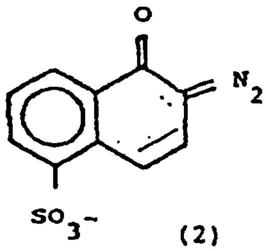

(2)

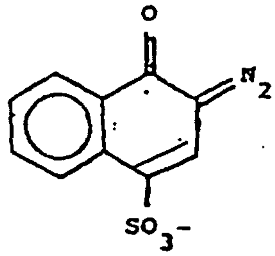

(2')

unter der Bedingung, dass mindestens 1 Mitglied von R1 bis R4 ein Radikal der Formel 2 oder 2' ist.

**9.** Zusammensetzungen nach Anspruch 8, **dadurch gekennzeichnet, dass** das Verbindungsgemisch nach Formel 1 aus folgenden Verbindungen besteht:

| | |
|---|---|
| Tetraester | 80- 100 Gewichtsprozent Gesamtfeststoffgehalt |
| Triester | 0 - 20 Gewichtsprozent Gesamtfeststoffgehalt |
| Diester | 0 - 5 Gewichtsprozent Gesamtfeststoffgehalt |
| Monoester | 0 - 5 Gewichtsprozent Gesamtfeststoffgehalt |

**10.** Zusammensetzungen nach Anspruch 9, **dadurch gekennzeichnet, dass** das Gemisch aus mindestens 85 Gewichtsprozent Gesamttrockensubstanz Tetraester, höchstens 10% Triester und in der Summe höchstens 5% Mono- und Diester besteht.

**11.** Zusammensetzungen nach einem der Ansprüche 1 bis 10, die 0,1 bis 5 Gewichtsprozent Gesamtfeststoffgehalt der Verbindung 3 enthalten:

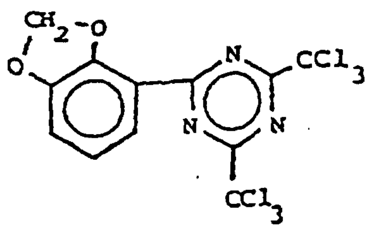

(3)

**12.** Zusammensetzungen nach einem der vorangegangenen Ansprüche, die eine geeignete Menge einer Säure mit einem pKa-Wert im Bereich von 3 bis 9 enthalten.

**13.** Verwendung der Zusammensetzungen nach Anspruch 1 bis 12 zur Herstellung von Offsetdruckplatten.

**14.** Offsetdruckplatten, **dadurch gekennzeichnet, dass** ihre lichtempfindliche Schicht ein Gemisch nach Anspruch 1 bis 12 aufweist.

**15.** Platten nach Anspruch 14, **dadurch gekennzeichnet, dass** die Trägersubstanz gekörntes und anodisch behandeltes Aluminium ist.

**16.** Gemisch von Verbindungen der Formel 1

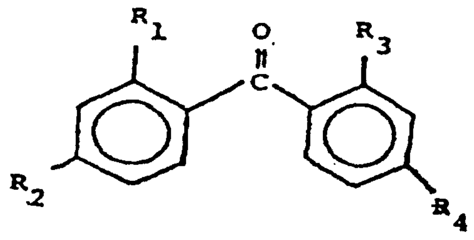

(1)

wobei R1, R2, R3 und R4 gleich oder verschieden voneinander sind und einen Hydroxylrest oder Radikal der Formel 2 oder 2' darstellen

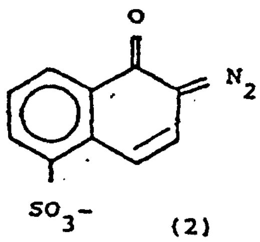

(2)

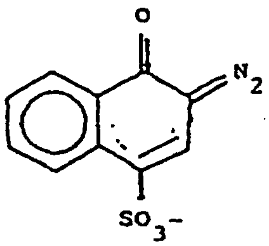

(2')

und die Mischung aus folgenden Verbindungen besteht

- 80-100% einer Verbindung der Formel 1, wobei R1, R2, R3 und R4 ein Radika der Formel 2 oder 2' sind,
- 0-20% einer Verbindung der Formel 1, wobei R1, R2, R3 und R4 ein Hydroxylrest sind;
- 0-5% einer Verbindung der Formel 1, wobei zwei Mitglieder aus R1, R2, R3 und R4 ein Hydroxylrest sind;
- 0-5% einer Verbindung der Formel 1, wobei drei Mitglieder aus R1, R2, R3 und R4 ein Hydroxylrest sind;

**17.** Gemisch nach Anspruch 16, das zumindest zu 85% aus einer Verbindung der Formel 1, **dadurch gekennzeichnet, dass** R1, R2, R3 und R4 ein Esterradikal der Formel 2 oder 2' sind; höchstens zu 10% aus einer Verbindung 1, **dadurch gekennzeichnet, dass** R1, R2, R3 und R4 ein Hydroxylrest sind, und in der Summe zu höchstens 5% aus Verbindungen der Formel 1 besteht, in denen zwei oder drei Mitglieder von R1, R2, R3 und R4 Hydroxylreste sind.

**18.** Verwendung der Zusammensetzungen nach Anspruch 16 oder 17 zur Herstellung eines lichtempfindlichen Gemischs für Offsetdruckplatten.

**Patentansprüche für folgende Vertragsstaaten : GB, DE**

**1.** Lichtempfindliche Zusammensetzungen, die einen Gesamtanteil von 20 bis 90 Gewichtsprozent an Feststoffen eines Diazoharzes mit einem Veresterungsindex im Bereich von 20 und 40% und einem Stickstoffgehalt zwischen 2 und 3%, einen Anteil von 0 bis 60 Gewichtsprozent an Feststoffen eines alkalilöslichen Novolak-Harzes sowie weitere herkömmliche Komponenten umfassen, wobei diese Zusammensetzungen einen als elektromotorische Kraft ausgedrückten Säurewert im Bereich von 100 und 400 mV haben, der in Dimethylketon mit einer speziellen Elektrode für wasserfreie Lösungsmittel gemessen wird, und die Zusammensetzungen ein UV-Absorbens umfassen, das eine Mischung aus mindestens 85 Gewichtsprozent Gesamtgehalt an Gemischfeststoffen Tetraester, höchstens 10 Gewichtsprozent Gesamtgehalt an Gemischfeststoffen Triester and in der Summe höchstens 5 Gewichtsprozent Gesamtgehalt an Gemischfeststoffen Mono- und Diester von 2,2',4,4-Tetrahydroxybenzophenon mit 1,2-Naphtochinondiazid-4- oder -5-Sulfonsäuren ist.

**2.** Zusammensetzungen nach Anspruch 1, **dadurch gekennzeichnet, dass** der Säurewert zwischen 150 und 300 Millivolt liegt.

**3.** Zusammensetzungen nach Anspruch 1 oder 2, **dadurch gekennzeichnet, dass** das Diazoharz aus dem Reaktionsprodukt von 1,2-Naphthochinon-Sulfonsäurediazid mit einem Phenolharz besteht.

4. Zusammensetzungen nach Anspruch 3, **dadurch gekennzeichnet, dass** das 1,2-Naphthochinon-Sulfonsäurediazid aus der aus 1,2-Naphthochinon-4-Sulfonsäurediazid und 1,2-Naphthochinon-5-Sulfonsäurediazid bestehenden Gruppe ausgewählt wird.

5. Zusammensetzungen nach Anspruch 3 oder 4, **dadurch gekennzeichnet, dass** das Phenolharz ein Kresol-Formaldehydharz ist.

6. Zusammensetzungen nach Anspruch 5, **dadurch gekennzeichnet, dass** das Kresol-Formaldehydharz ein Molekulargewicht zwischen 600 und 900 hat.

7. Zusammensetzungen nach einem der Ansprüche 1 bis 6, die 0,1 bis 5 Gewichtsprozent Gesamtgehalt an Feststoffen der Verbindung 3 enthalten:

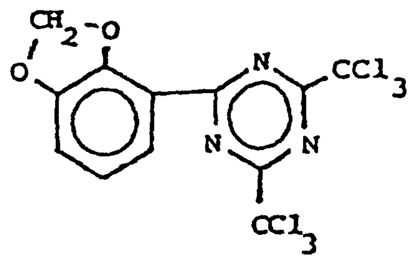

(3)

8. Zusammensetzungen nach einem der vorangegangenen Ansprüche, die eine geeignete Menge einer Säure mit einem pKa-Wert im Bereich von 3 bis 9 enthalten.

9. Verwendung der Zusammensetzungen nach Anspruch 1 bis 8 zur Herstellung von Offsetdruckplatten.

10. Offsetdruckplatten, **dadurch gekennzeichnet, dass** ihre lichtempfindliche Schicht ein Gemisch nach Anspruch 1 bis 8 aufweist.

11. Platten nach Anspruch 10, **dadurch gekennzeichnet, dass** die Trägersubstanz gekörntes und anodisch behandeltes Aluminium ist.

12. Gemisch von Verbindungen der Formel 1:

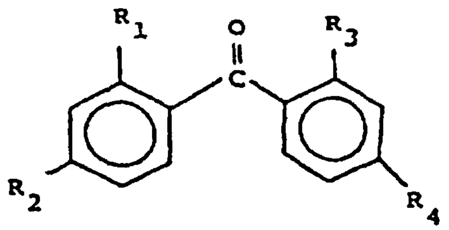

(1)

wobei R1, R2, R3 und R4 gleich oder verschieden voneinander sind und einen Hydroxylrest oder Radikal der Formel 2 oder 2' darstellen

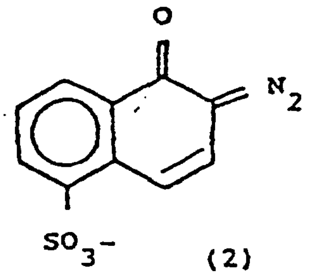

(2)

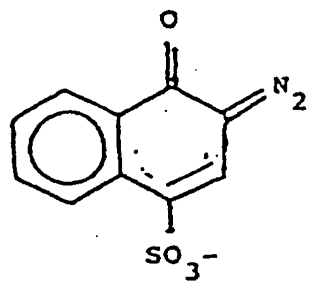

(2')

und die Mischung aus folgenden Verbindungen besteht

- 80 bis 100% einer Verbindung der Formel 1, wobei R1, R2, R3 und R4 ein Radikal der Formel 2 oder 2' ist;
- 0-20% einer Verbindung der Formel 1, wobei R1, R2, R3 und R4 ein Hydroxylrest sind;0-5% einer Verbindung der Formel 1, wobei zwei Mitglieder aus R1, R2, R3 und R4 ein Hydroxylrest sind;
- 0-5% einer Verbindung der Formel 1, wobei drei Mitglieder aus R1, R2, R3 und R4 ein Hydroxylrest sind;

**13.** Gemisch nach Anspruch 12, das zumindest zu 85% aus einer Verbindung der Formel 1, **dadurch gekennzeichnet, dass** R1, R2, R3 und R4 ein Esterrest der Formel 2 oder 2' sind; höchstens zu 10% aus einer Verbindung der Formel 1, **dadurch gekennzeichnet, dass** R1, R2, R3 und R4 ein Hydroxylrest sind, und in der Summe zu höchstens 5% aus Verbindungen der Formel 1 besteht, in denen zwei oder drei Mitglieder von R1, R2, R3 und R4 Hydroxylreste sind.

**14.** Verwendung der Zusammensetzungen nach Anspruch 12 oder 13 zur Herstellung eines lichtempfindlichen Gemischs für Offsetdruckplatten.

## Revendications

### Revendications pour les Etats contractants suivants : AT, BE, CH, LI, DK, ES, FI, FR, GR, IE, IT, LU, MC, NL, PT, SE

**1.** Compositions photosensibles comprenant de 20 à 90 % en poids des solides totaux d'une résine diazoïque présentant un indice d'estérification compris entre 20 et 40 % et une teneur en azote comprise entre 2 et 3 %, de 0 à 60 % en poids des solides totaux d'une résine novolac soluble dans les alcalis, ainsi que tout autre composant classique, **caractérisées en ce que** lesdites compositions présentant une valeur d'acidité, exprimée en tant que Force Electromotrice mesurée dans la diméthylcétone à l'aide d'une électrode spécifique pour solvants non aqueux, qui est comprise entre 100 et 400 millivolts.

**2.** Compositions selon la revendication 1, **caractérisées en ce que** ladite valeur d'acidité est comprise entre 150 et 300 millivolts.

**3.** Compositions selon la revendication 1 ou 2, dans lesquelles ladite résine diazoïque est constituée par le produit de réaction d'un diazide de l'acide 1,2-naphtoquinone sulfonique avec une résine phénolique.

**4.** Compositions selon la revendication 3, dans lesquelles ledit diazide de l'acide 1,2-naphtoquinone sulfonique est sélectionné dans le groupe constitué par le diazide de l'acide 1,2-naphtoquinone-4-sulfonique et le diazide de l'acide 1,2-naphtoquinone-5-sulfonique.

**5.** Compositions selon la revendication 3 ou 4, dans lesquelles ladite résine phénolique est une résine de formaldéhyde de crésol.

**6.** Compositions selon la revendication 5, dans lesquelles ladite résine de formaldéhyde de crésol présente un poids moléculaire compris entre 600 et 900.

**7.** Compositions selon l'une quelconque des revendications précédentes, contenant en outre au moins un composé absorbant les UV.

**8.** compositions selon la revendication 7, dans lesquelles ledit agent d'absorption des UV est un composé ou un mélange de composés de formule 1

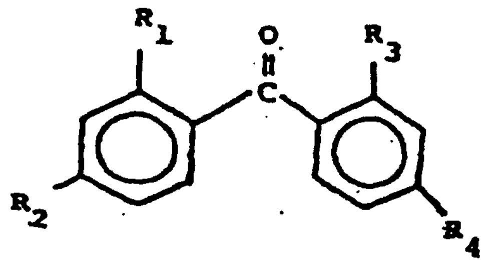

(1)

où $R_1$, $R_2$, $R_3$ et $R_4$, identiques ou différents les uns des autres, représentent un hydroxyle ou un radical de formule 2 ou 2'

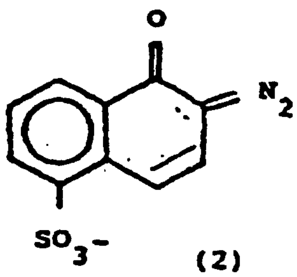

(2)

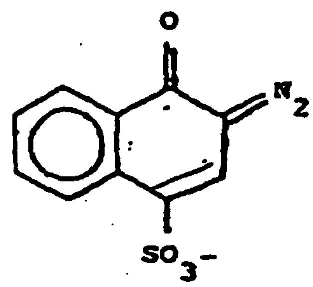

(2')

avec la condition qu'au moins l'un parmi $R_1$ à $R_4$ soit un radical de formule 2 ou 2'.

**9.** Compositions selon la revendication 8, dans lesquelles ledit mélange de composés de formule 1 est constitué de :

| | |
|---|---|
| tétraester | 80 - 100 % en poids des solides totaux |
| triester | 0 - 20 % en poids des solides totaux |
| diester | 0 - 5 % en poids des solides totaux |
| monoester | 0 - 5 % en poids des solides totaux. |

**10.** compositions selon la revendication 9, dans lesquelles ledit mélange est constitué de : au moins 85 % en poids des solides totaux de tétraester, pas plus de 10 % de triester et pas plus de 5 % de la somme du mono-et du diester.

**11.** compositions selon l'une quelconque des revendications 1 à 10, contenant de 0,1 à 5 % en poids des solides totaux du composé 3 :

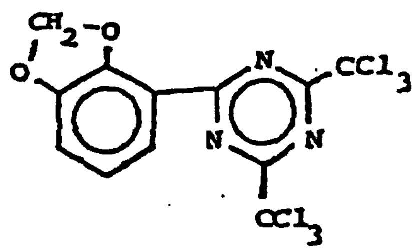

(3)

12. Compositions selon l'une quelconque des revendications précédentes, contenant une quantité appropriée d'un acide présentant un pKa d'une valeur comprise entre 3 et 9.

13. utilisation des compositions selon les revendications 1 à 12 pour la fabrication de plaques d'impression offset.

14. Plaques d'impression offset **caractérisées en ce que** la couche sensible comprend un mélange selon les revendications 1 à 12.

15. Plaques selon la revendication 14, dans lesquelles le substrat est en aluminium grainé et anodisé.

16. Mélange de composés de formule 1 :

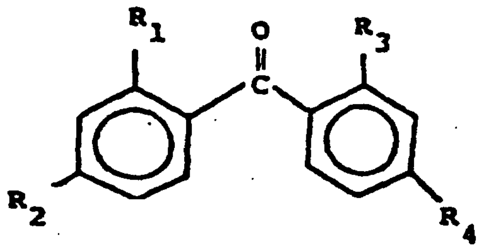

(1)

où $R_1$, $R_2$, $R_3$ et $R_4$, identiques ou différents les uns des autres, représentent un hydroxyle ou un radical de formule 2 ou 2'

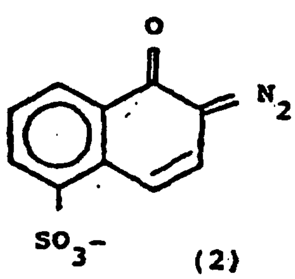

(2)

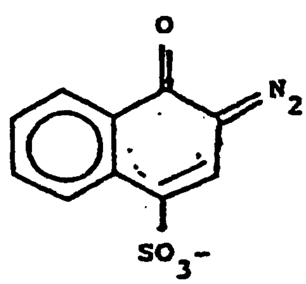

(2')

ledit mélange étant constitué par :

- 80 - 100 % d'un composé de formule 1, où $R_1$, $R_2$, $R_3$ et $R_4$ représentent un radical de formule 2 ou 2' ;
- 0 - 20 % d'un composé de formule 1, dans laquelle l'un parmi $R_1$, $R_2$, $R_3$ et $R_4$ représente un hydroxyle ;
- 0 - 5 % d'un composé de formule 1, dans laquelle eux parmi $R_1$, $R_2$, $R_3$ et $R_4$ représentent un hydroxyle ;
- 0 - 5 % d'un composé de formule 1, dans laquelle trois parmi $R_1$, $R_2$, $R_3$ et $R_4$ représentent un hydroxyle.

17. Mélange selon la revendication 16, constitué d'au moins 85 % d'un composé de formule 1, dans laquelle $R_1$, $R_2$, $R_3$ et $R_4$ représentent un radical ester de formule 2 ou 2' ; pas plus de 10% d'un composé de formule 1, dans laquelle l'un parmi $R_1$, $R_2$, $R_3$ et $R_4$ représente un hydroxyle et pas plus de 5 % de la somme des composés de formule 1 dans laquelle deux ou trois parmi $R_1$, $R_2$, $R_3$ et $R_4$ représentent un hydroxyle.

18. Utilisation du mélange selon la revendication 16 ou 17 pour la fabrication d'un mélange photosensible pour des plaques d'impression offset.

**Revendications pour les Etats contractants suivants : GB, DE**

1. Compositions photosensibles comprenant de 20 à 90 % en poids des solides totaux d'une résine diazoïque présentant un indice d'estérification compris entre 20 et 40 % et une teneur en azote comprise entre 2 et 3 %, de 0 à 60 % en poids des solides totaux d'une résine novolac soluble dans les alcalis, ainsi que tout autre composant classique, lesdites compositions présentant une valeur d'acidité, exprimée en tant que Force Electromotrice et mesurée dans la diméthylcétone à l'aide d'une électrode spécifique pour solvants non aqueux, qui est comprise entre 100 et 400 millivolts et lesdites compositions comprenant un agent d'absorption des UV qui est un mélange d'au moins 85 % en poids, des solides totaux du mélange, de tétraester, de pas plus de 10 % en poids, des solides totaux du mélange de triester et pas plus de 5 % en poids, des solides totaux du mélange de la somme de mono- et diester de 2,2',4,4'-tétrahydroxybenzophénone avec des acides et de 1,2-naphtoquinone diazide-4- ou-5-sulfonique.

2. Compositions selon la revendication 1, **caractérisées en ce que** ladite valeur d'acidité est comprise entre 150 et 300 millivolts.

3. compositions selon la revendication 1 ou 2, dans lesquelles ladite résine diazoïque est constituée par le produit de réaction d'un diazide de l'acide 1,2-naphtoquinone sulfonique avec une résine phénolique.

4. compositions selon la revendication 3, dans lesquelles ledit diazide de l'acide 1,2-naphtoquinone sulfonique est sélectionné dans le groupe constitué par le diazide le l'acide 1,2-naphtoquinone-4-sulfonique et le diazide de l'acide 1,2-naphtoquinone-5-sulfonique.

5. Compositions selon la revendication 3 ou 4, dans lesquelles ladite résine phénolique est une résine de formaldéhyde de crésol.

6. Compositions selon la revendication 5, dans lesquelles ladite résine de formaldéhyde de crésol présente un poids moléculaire compris entre 600 et 900.

7. Compositions selon l'une quelconque des revendications 1 à 6, contenant de 0,1 à 5 % en poids des solides totaux du composé 3 :

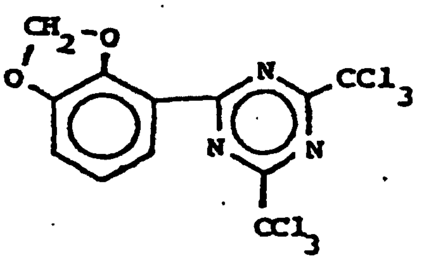

(3)

8. compositions selon l'une quelconque des revendications précédentes, contenant une quantité appropriée d'un acide présentant un pKa d'une valeur comprise entre 3 et 9.

9. utilisation des compositions selon les revendications 1 à 8 pour la fabrication de plaques d'impression offset.

10. Plaques d'impression offset **caractérisées en ce que** la couche sensible comprend un mélange selon les revendications 1 à 8.

**11.** Plaques selon la revendication 10, dans lesquelles le substrat est en aluminium grainé et anodisé.

**12.** Mélange de composés de formule 1 :

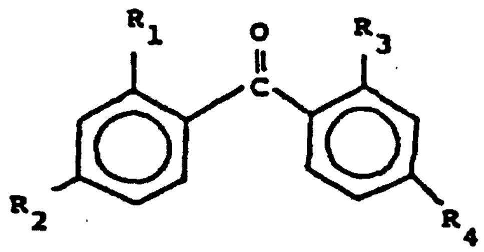

(1)

où $R_1$, $R_2$, $R_3$ et $R_4$, identiques ou différents les uns des autres, représentent un hydroxyle ou un radical de formule 2 ou 2'

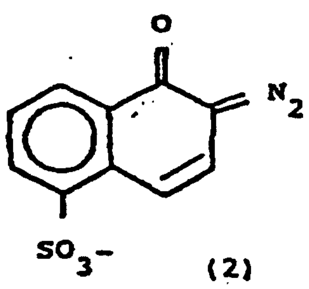

(2)

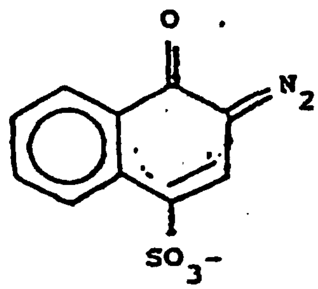

(2')

ledit mélange étant constitué par :

- 80 - 100 % d'un composé de formule 1, où $R_1$, $R_2$, $R_3$ et $R_4$ représentent un radical de formule 2 ou 2' ;
- 0 - 20 % d'un composé de formule 1, dans laquelle l'un parmi $R_1$, $R_2$, $R_3$ et $R_4$ représente un hydroxyle ;
- 0 - 5 % d'un composé de formule 1, dans laquelle deux parmi $R_1$, $R_2$, $R_3$ et $R_4$ représentent un hydroxyle ;
- 0 - 5 % d'un composé de formule 1, dans laquelle trois parmi $R_1$, $R_2$, $R_3$ et $R_4$ représentent un hydroxyle.

**13.** Mélange selon la revendication 12, constitué d'au moins 85 % d'un composé de formule 1, dans laquelle $R_1$, $R_2$, $R_3$ et $R_4$ représentent un radical ester de formule 2 ou 2' ; pas plus de 10 % d'un composé de formule 1 dans laquelle l'un parmi $R_1$, $R_2$, $R_3$ et $R_4$ représente un hydroxyle et pas plus de 5 % de la somme des composés de formule 1 dans laquelle deux ou trois parmi $R_1$, $R_2$, $R_3$ et $R_4$ représentent un hydroxyle.

**14.** utilisation du mélange selon la revendication 12 ou 13 pour la fabrication d'un mélange photosensible pour des plaques d'impression offset.